(19) Europäisches Patentamt

European Patent Office

Office européen des brevets

(11) **EP 0 908 961 B1**

(12) **FASCICULE DE BREVET EUROPEEN**

(45) Date de publication et mention
de la délivrance du brevet:
**04.06.2003 Bulletin 2003/23**

(51) Int Cl.⁷: **H01L 41/09**, H01L 41/12

(21) Numéro de dépôt: **98402519.7**

(22) Date de dépôt: **12.10.1998**

(54) **Actionneur amplifié à matériaux actifs**

Verstärker-Antrieb mit aktiven Materialien

Amplifier actuator using active materials

(84) Etats contractants désignés:
**DE ES GB IT NL SE**

(30) Priorité: **13.10.1997 FR 9712774**
**13.10.1997 FR 9712775**

(43) Date de publication de la demande:
**14.04.1999 Bulletin 1999/15**

(73) Titulaire: **Sagem S.A.**
**75015 Paris (FR)**

(72) Inventeur: **Audren, Jean Thierry**
**78470 Saint Rémy les Chevreuses (FR)**

(74) Mandataire: **Schrimpf, Robert**
**Cabinet Regimbeau**
**20, rue de Chazelles**
**75847 Paris cedex 17 (FR)**

(56) Documents cités:
**EP-A- 0 516 175        US-A- 5 001 382**
**US-A- 5 626 312**

## Description

La présente invention est relative à des actionneurs amplifiés à matériaux actifs de type piezoélectrique, électrostrictif ou magnétostrictif.

Il existe à bord des aéronefs deux types de commande de vol :

- les commandes primaires qui servent à commander les mouvements immédiats de l'avion ; ce sont en général des volets situés dans les bords de fuite des ailes ;
- les commandes de vol secondaires qui servent à régler la configuration aérodynamique de l'aéronef en conformité avec les phases de vol. On trouve dans cette catégorie les becs et volets hypersustentateurs et le plan fixe arrière.

Les caractéristiques demandées aux actionneurs de ces surfaces sont extrêmement différentes.

Les commandes primaires doivent en effet supporter une bande passante supérieure à la largeur du spectre des mouvements de l'avion, assurer un fonctionnement permanent, permettre un retour à la position neutre en cas de coupure de l'énergie.

Les commandes secondaires doivent quant à elles présenter une bande passante faible, pour un fonctionnement intermittent, et permettre de maintenir la dernière position en cas de coupure de l'énergie.

Ces commandes sont en général réalisées par des dispositifs hydrauliques qui, pour les commandes primaires, sont à commande directe et pour les commandes secondaires réalisent la commande à travers des moyens formant réducteur mécanique. Ce sont ces moyens formant réducteur mécanique, qui dans le deuxième cas assurent l'irréversibilité demandée.

Pour diverses raisons (maintenance, pollution, risque d'incendie, etc...), les constructeurs d'avion cherchent à réduire la part de l'hydraulique dans la commande au profit de commandes électriques. Cependant, la technologie des moteurs électromagnétiques associés aux moyens formant réducteur conduit à des équipements dont la masse est trop élevée.

Un but de l'invention est de proposer des moteurs à base de matériaux piezoélectriques, électrostrictifs ou magnétostrictifs aptes à présenter des densités d'énergie élevée et capables de supporter des contraintes élevées, et constituant par conséquent des candidats intéressants pour la commande primaire.

Il a déjà été proposé de réaliser des actionneurs au moyen de moteurs à vibrations, dans lesquels des vibrations tangentielles et normales générées sur un stator sont transformées en mouvement continu grâce au frottement du contact mécanique entre ledit stator et le rotor.

Pour une présentation générale d'applications de ce type de moteur aux commandes de vol secondaires, on pourra par exemple se référer à :

« Actionneurs- Des matériaux piézoélectriques pour les commandes du futur » - Usine nouvelle - 31 octobre 1996 - n°2568
« Des commandes de vol piézoélectriques » - Air et Cosmos/Aviation International - n°1602 - 28 février 1997

Toutefois, ce type de moteur ne peut être utilisé pour réaliser des commandes primaires, étant donné que le fonctionnement permanent conduit à une usure trop rapide de l'interface et au maintien de la dernière position en cas de coupure de l'énergie.

Une autre solution, également déjà proposée, consiste à utiliser directement le déplacement piezoélectrique pour réaliser le débattement limité de la gouverne. Comme les matériaux piezoélectriques sont capables de très fortes contraintes mais ne permettent que de très faibles déplacements, il convient de les inclure dans des structures qui augmentent le déplacement afin qu'ils soient compatibles avec le mouvement demandé pour les gouvernes. Ces dispositifs sont communément appelés « amplificateurs » bien que l'énergie d'entrée reste toujours plus grande que l'énergie de sortie.

Des structures d'actionneurs amplifiés ont par exemple été décrites dans :

« A new amplifier piezoelectric actuator for precise positioning and semi--passive damping » - R. Le Letty, F. Claeyssen, G. Thomin - 2nd space microdynamics and accurate control symposium - 13-16 Mai 1997 - Toulouse.

Dans cet article, il était proposé d'utiliser comme amplificateur en sortie de l'actionneur piézoélectrique un amplificateur mécanique élastique. D'autres encore ont proposé d'utiliser comme amplificateur des moyens de conversion hydraulique (c. f. article déjà cité paru dans Usine Nouvelle).

Toutefois, ces solutions ne sont pas satisfaisantes. La structure qui réalise la conversion doit en effet être plus rigide que l'actionneur de base faute de quoi l'énergie de l'actionneur de départ sert à déformer la structure de conversion au détriment de l'énergie de sortie. Et cette rigidité est souvent obtenue par l'emploi de pièces massives, ce qui réduit considérablement l'avantage initial de légèreté et de densité d'énergie élevée.

C'est donc l'objet de l'invention de proposer une structure rigide et légère convertissant les petits déplacements piézoélectriques élémentaires en grands déplacements.

A cet effet, l'invention propose quant à elle un actionneur caractérisé en ce qu'il comporte une pluralité d'empilements de blocs élémentaires en un matériau actif de type piézoélectrique, électrostrictif ou magnétostrictif, qui sont répartis en plusieurs couches empilées dans lesquelles ils sont juxtaposés en étant refermés annulairement en rondelle R de façon à former une structure tubulaire, ainsi que des moyens permettant d'appliquer sur lesdits blocs élémentaires un champ électrique ou magnétique déformant lesdits blocs élémentaires de telle sorte que la structure tubulaire se vrille.

Selon des premières variantes de réalisation, les blocs élémentaires sont piézoélectriques ou électrostrictifs, et les moyens pour déformer lesdits blocs comportent des moyens formant électrodes permettant d'appliquer des champs électriques sur lesdits blocs.

Un tel actionneur est avantageusement complété par les différentes caractéristiques suivantes prises seules ou selon toutes leurs combinaisons possibles :

- les blocs élémentaires travaillent en allongement/ rétraction et sont empilés avec une polarisation alternée dans la hauteur de la structure tubulaire ;
- les empilements sont séparés deux à deux par des moyens de séparation qui s'étendent selon la hauteur de la structure et les éléments de séparation sont constitués d'une succession de pavés qui présentent chacun une hauteur correspondant au moins à la hauteur de deux blocs élémentaires, ces pavés étant aptes à glisser les uns sur les autres et étant d'une raideur supérieure à celle des blocs élémentaires, les zones de séparation entre les pavés superposés selon une même hauteur étant, d'un moyen de séparation à un autre, décalés dans la hauteur de la structure ;
- les moyens de séparation sont constitués par des bandes qui présentent une pluralité de fentes qui délimitent deux à deux les pavés ;
- les moyens de séparation sont constitués par une pluralité d'éléments de séparation qui sont superposés et qui constituent chacun un pavé élémentaire ;
- les moyens formant électrodes sont constitués par les moyens de séparation ;
- les blocs élémentaires travaillent en cisaillement ;
- deux blocs élémentaires successifs dans la hauteur d'un même empilement présentent des métallisations formant électrode sur leurs faces en regard ;
- les empilements de blocs élémentaires sont séparés par des moyens de séparation électriquement conducteurs auxquels les métallisations formant électrode sont reliées ;
- les blocs élémentaires sont répartis en rondelle dans la hauteur de la structure tubulaire ;
- l'actionneur comporte une enveloppe de précontrainte dans laquelle la structure tubulaire à blocs élémentaires est disposée ;
- l'enveloppe de précontrainte comprend une pluralité de bagues assurant chacune la précontrainte d'une rondelle de blocs élémentaires de la structure tubulaire ;
- les bagues sont électriquement conductrices et l'actionneur comporte une pluralité de plots de contacts répartis dans la hauteur de la structure entre les moyens de séparation et les bagues de précontrainte ;
- les plots de contact sont répartis de façon à être en contact avec un pavé sur deux ;
- les bagues sont séparées par des rondelles électriquement isolantes ;
- l'enveloppe ou les bagues de précontrainte est ou sont en un alliage à mémoire de forme.

Un tel actionneur est avantageusement réalisé de la façon suivante :

a) on empile dans un tube externe une alternance de bagues de précontrainte en phase basse température et de rondelles isolantes,
b) on colle le long des génératrices d'un noyau interne cylindrique de surface isolante, des bandes métalliques fendues, en les décalant deux à deux, le long dudit noyau, d'une demi épaisseur de noyau,
c) on introduit le noyau et ses bandes dans la structure tubulaire que constituent les bagues de précontrainte et les rondelles,
d) on introduit les blocs élémentaires dans les logements entre les bagues, les bandes et le noyau,
e) on chauffe l'ensemble de façon à provoquer le changement de phase des bagues de précontrainte.

Selon d'autres variantes de réalisation encore, les blocs élémentaires de la structure active tubulaire comprennent une pluralité d'empilements de pavés destinés à être déformés par effet magnétostrictif entre lesquels sont interposés des moyens de séparation constitués d'empilements de pavés de séparation présentant chacun une hauteur correspondant au moins à la hauteur de deux pavés destinés à être déformés par effet magnétostrictif, les différents pavés superposés dans une hauteur de la structure active étant aptes à glisser les uns sur les autres, les zones de séparation entre les pavés de séparation superposés selon une même hauteur étant, d'un moyen de séparation à un autre, décalés dans la hauteur de la structure, l'actionneur comportant en outre des moyens pour appliquer sur les pavés destinés à être déformés par effet magnétostrictif un champ magnétique qui produit, de façon alternée dans la hauteur de la structure et sur le tour de celle-ci, la rétraction et l'allongement desdits pavés.

Un tel actionneur est avantageusement complété par les différentes caractéristiques suivantes prises seules ou selon toutes leurs combinaisons possibles :

- la structure active est un tube en un matériau magnétostrictif, qui présente une pluralité de fentes disposées en quinconce qui définissent entre elles des zones correspondant aux pavés destinés à être déformés par effet magnétostrictif et des zones correspondant aux pavés de séparation ;

- l'actionneur comporte des moyens pour appliquer un champ magnétique radial permanent uniforme sur la structure active et pour ajouter à ce champ permanent un champ de commande radial qui est alterné d'un pavé qui est destiné à être déformé par effet magnétostrictif à un autre ;
- il comporte des moyens pour appliquer sur la structure active un champ radial permanent alterné d'un pavé qui est destiné à être déformé par effet magnétostrictif à un autre et pour ajouter à ce champ permanent un champ de commande radial uniforme ;
- il comporte des aimants permanents en regard des différents pavés destinés à être déformés par effet magnétostrictif ;
- les aimants permanents présentent une polarisation qui est alternée d'un aimant à un autre ;
- les aimants permanents sont portés par un noyau qui comprend une pluralité de tronçons aptes à tourner les uns par rapport aux autres et l'actionneur comporte en outre des moyens pour communiquer à ces tronçons le mouvement de vrille de la structure active ;
- lesdits moyens comportent une barre de torsion axiale ;
- lesdits moyens comportent des liaisons en élastomère entre des aimants permanents successifs dans la hauteur de la structure active.

La description qui suit est purement illustrative et non limitative. Elle doit être lue en regard des dessins annexés sur lesquels

- La figure 1 est une représentation schématique en perspective d'un actionneur conforme à un mode de réalisation possible de l'invention.
- La figure 2 est une représentation développée de la structure active de l'actionneur de la figure 1.
- La figure 3 est une représentation semblable à celle de la figure 2 illustrant le fonctionnement de la structure active.
- La figure 4 est une représentation développée d'une autre variante de réalisation possible dans la structure active.
- La figure 5 illustre le glissement entre deux pavés des moyens de séparation de la structure de la figure 4.
- La figure 6 est une représentation en coupe transversale de l'actionneur de la figure 1.
- La figure 7 est une représentation schématique en perspective illustrant un mode de réalisation possible pour l'enveloppe de précontrainte.
- La figure 8 est une représentation en perspective illustrant un mode de réalisation possible pour des moyens de séparation.
- Les figures 9a à 9d sont des représentations schématiques illustrant différents étapes de réalisation de l'actionneur de la figure 1.

- Les figures 10 et 11 sont des représentations semblables à celles des figures 2 et 3 illustrant un autre mode de réalisation possible de l'invention.
- La figure 12 est une représentation semblable à celle de la figure 10 illustrant une autre variant de réalisation encore possible.
- La figure 13 est une représentation schématique en perspective semblable à celle de la figure 1 illustrant un actionneur magnétostrictif conforme à une autre variante de réalisation possible.
- La figure 14 est une représentation sous forme développée de la structure active de l'actionneur de la figure 13.
- La figure 15 est une représentation semblable à celle de la figure 14 illustrant le mouvement de vrille de la structure active.
- La figure 16 est une représentation semblable à celle de la figure 14 illustrant un autre mode de réalisation possible pour l'invention.
- La figure 17 est un graphe sur lequel on a porté l'allongement L d'un matériau magnétostrictif en fonction du champ magnétique B qui lui est appliqué.
- La figure 18 est une demi vue en coupe radiale de l'actionneur de la figure 15.
- La figure 19 est une vue en coupe transversale du même actionneur.
- La figure 20 est une représentation semblable à celle de la figure 17 illustrant un autre mode de réalisation de l'invention.
- Les figures 21 et 22 illustrent deux types de structure possible pour la tige de la structure de la figure 18 ou de la figure 20.

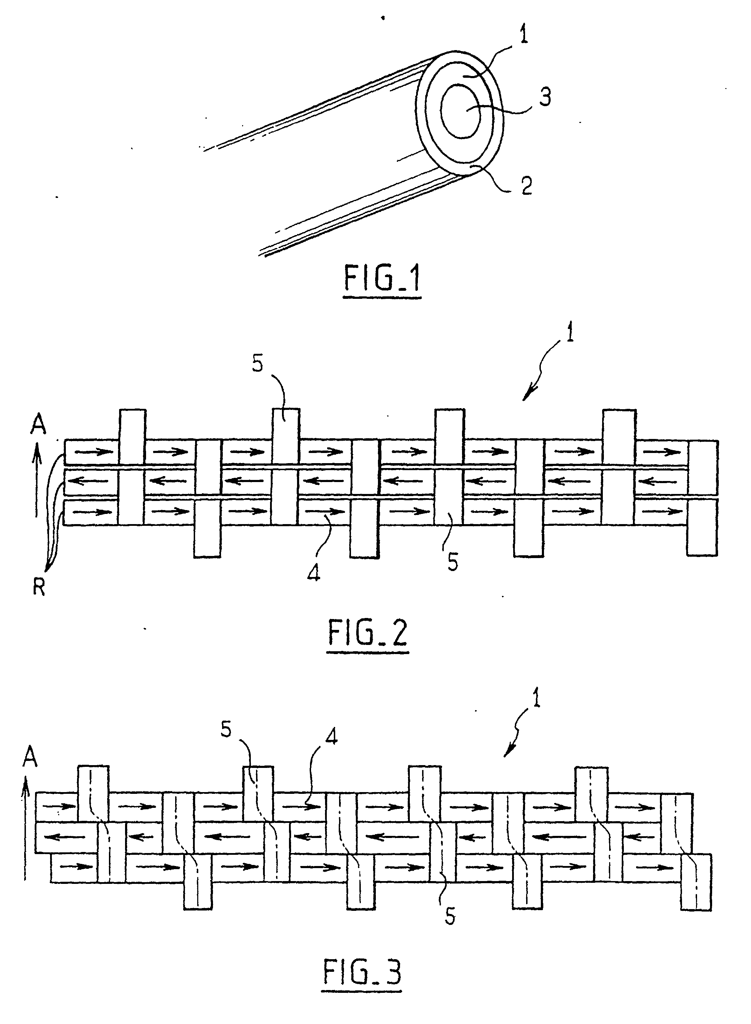

L'actionneur conforme à un mode de réalisation possible qui est illustré sur la figure 1 a une forme cylindrique et comporte une structure active 1 tubulaire, ainsi qu'une enveloppe de précontrainte 2 dans laquelle la structure active 1 est montée. Il comporte en outre éventuellement un noyau central 3, qui sert principalement à la construction de l'actionneur et qui, comme cela sera explicité plus loin de façon détaillée, peut le cas échéant être retiré à la fin de la fabrication.

Cet actionneur cylindrique prend un mouvement de torsion important autour de son axe de révolution lorsque l'on applique une tension de commande sur son enveloppe de précontrainte. Cette torsion peut, avec les structures actives 1 qui vont être décrites, atteindre 0,25 rd soit 15°.

La figure 2 représente sous forme développée une petite hauteur d'une structure active 1 conforme à un mode de réalisation possible.

L'axe A représente la direction de l'axe du cylindre.

Les rectangles comportant une flèche dessinée en leur centre représentent des blocs de matériau piezoélectrique ou électrostrictifs, qui ont été référencés par 4.

Ces blocs 4 sont soit des blocs massifs de céramique, soit des blocs multicouche. Dans le premier cas, le sens de la flèche correspond à l'orientation de la polarisation. Dans le second cas, le sens de la flèche correspond à l'orientation de la polarisation des couches extrêmes.

Les blocs 4 sont empilés dans la hauteur de la structure et chaque couche d'empilement est constituée d'une pluralité de blocs 4 qui sont juxtaposés de façon à se refermer annulairement et à constituer une rondelle R.

Sur une même couche d'empilement, les blocs 4 successifs sont séparés deux à deux par des éléments de séparation 5 inertes (pavés), qui s'étendent chacun sur deux couches d'empilement. Ces éléments de séparation sont en des matériaux de raideurs plus élevées que celles de la céramique des blocs 4. Ils sont par exemple en acier.

Les éléments de séparation 5 successifs d'une même couche d'empilement s'étendent alternativement à travers l'un et l'autre des deux couches d'empilement de part et d'autre de la couche d'empilement considérée et constituent des éléments de séparation pour les blocs 4 de respectivement l'une et l'autre de ces deux couches.

Deux éléments de séparation 5 successifs dans la hauteur de l'axe A de la structure sont en contact l'un avec l'autre, mais sont aptes à se décaler l'un par rapport à l'autre.

Les sens de polarisation des blocs 4 (ou de leurs couches externes dans le cas de matériau multicouches) sont alternés d'une couche d'empilement à une autre.

Si l'on applique une tension alternée (+V, -V) sur les alignements selon l'axe A des éléments de séparation 5, on produit un mouvement de décalage de chaque couche par rapport à sa voisine. Du fait de l'alternance des champs dans chaque rondelle R et de l'alternance de polarisation d'une rondelle R à l'autre le décalage est toujours dans le même sens.

C'est ce qu'illustre la figure 3.

En supposant que la déformation du matériau des éléments de séparation 5 (métal) est négligeable par rapport à celle de la céramique des blocs 4 (grande différence de module d'Young) et que les éléments 5 se déplacent en restant parallèle à eux-mêmes, on a en première approximation :

$$\theta = 2\pi\mu\varepsilon m/n$$

$$K = (E/2\pi\mu)(n^2/m^2)R.\Delta R.l$$

avec

θ = torsion maximale de l'arbre sous tension
m = nombre de couches dans le cylindre

ε = déformation relative maximale sous champ de la céramique
μ = rapport volume de céramique p
*ar rapport au volume totla métal + céramique,
R = rayon externe de la structure active,
K = raideur en torsion de l'arbre
n = nombre de pavés de céramique dans une rondelle
E = module d'Young de la céramique,
ΔR = différence entre le rayon externe et le rayon interne de la couche active,
| = longueur de l'actionneur.

A l'aide de ces deux formules, on peut choisir les caractéristiques que l'on désire pour l'arbre que constitue l'actionneur cylindrique. On voit que le rapport μm/n représente le coefficient d'amplification mécanique. On cherche pour un grand rapport à avoir un grand nombre de couches avec un minimum de blocs par couche.

Le rapport μdoit également être élevé mais il convient de le laisser plus faible que 0,5. En effet, lorsque ce rapport augmente, les éléments de séparation 5 métalliques subissent un mouvement de torsion préjudiciable au fonctionnement du dispositif.

Pour pouvoir augmenter μ tout en évitant au mieux ce phénomène, on peut avantageusement remplacer. les éléments de séparation 5 individuels par des éléments de séparation constituées de bandes 6, par exemple métalliques, qui sont parallèles à l'axe A du cylindre et dans lesquelles sont intégrées des fentes 7.

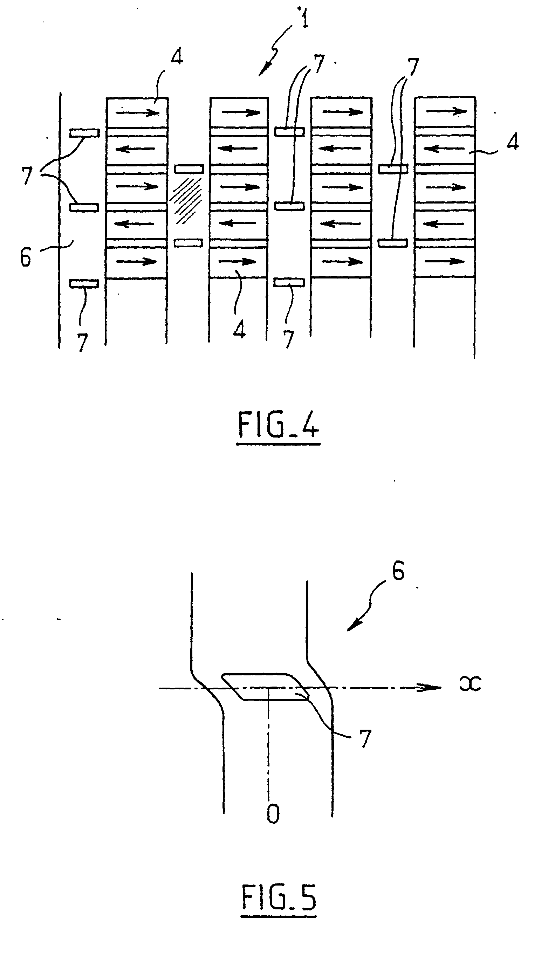

Une variante en ce sens est illustrée sur la figure 4.

Les fentes 7 d'une bande 6 sont séparées d'une distance qui correspond à la hauteur de deux couches de blocs 4 successives.

D'une bande à l'autre, ces fentes 7 sont décalées de la hauteur d'une couche de blocs 4.

Avec une telle structure, la masse métallique (pavé) entre deux fentes 7 successives d'une bande représente l'équivalent d'un élément de séparation 5 dans la structure décrite en référence aux figures 2 et 3 et lesdites fentes 7 simulent des liaisons entre les éléments de séparation 5 qui autorisent le glissement d'un élément 5 par rapport à l'autre et limitent le basculement.

Une déformation de la zone d'une bande 6 autour d'une fente 7 est illustrée sur la figure 5.

On notera que les fentes 7 éliminent une grande partie des contraintes de cisaillement qui sont uniformément réparties dans la surface lors de la translation et maximise les contraintes de traction/compression qui sont importantes sur les bords du éléments de séparation 5 lors d'un basculement.

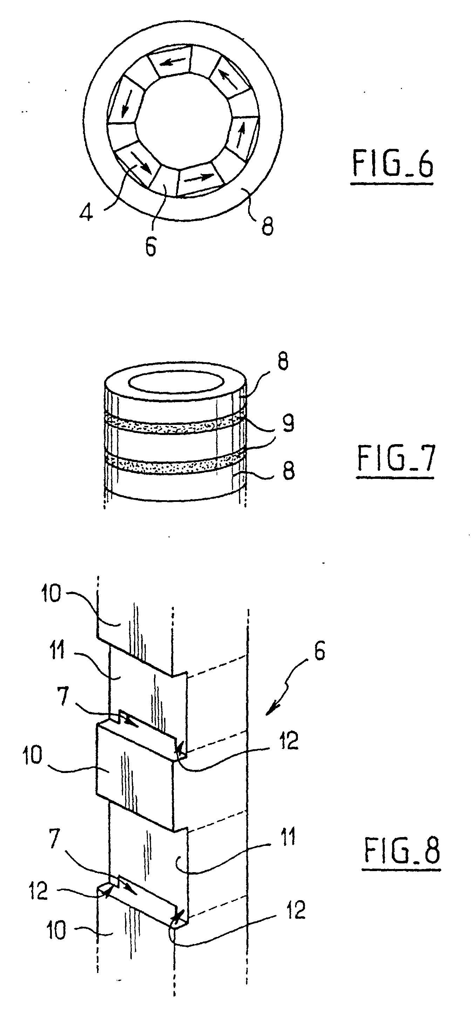

L'enveloppe de précontrainte 2 est réalisée pour chaque couche du cylindre à l'aide d'une bague de précontrainte 8 qui serre l'ensemble métal/céramique de la façon qui est illustrée sur la figure 6.

On utilise avantageusement pour réaliser les bagues de pécontrainte 8 un alliage à mémoire de forme avec un grand hystéresis en température du type Ni-Ti-Nb. Dans sa phase basse température obtenue par trempage dans l'azote liquide cette bague 8 présente à température ordinaire un diamètre intérieur suffisant pour construire l'alternance céramique-métal. En chauffant à plus de 150°C la bague 8 prend sa structure haute température en se resserrant et assure ainsi la précontrainte. Elle garde cette structure même en revenant aux températures usuelles d'utilisation ( - 60°C à +100°C).

Pour éviter les courts-circuits entre les circuits d'alimentation + V et - V, seule une bande 6 (ou un élément de séparation 5) sur deux est en contact avec la bague 8.

Le contact est préférentiellement assuré par des plots de contact 10.

Et pour homogénéiser la précontrainte, on alterne d'une couche à l'autre la répartition des plots de contact. Ceci a pour résultat que chaque bague de précontrainte 8 est à un potentiel opposé à celui de sa voisine immédiate. Il convient donc, ainsi que l'illustre la figure 7, d'intercaler entre les bagues de précontrainte 8 des rondelles d'isolement électrique 9.

Un exemple de structure possible pour une bande 6 de séparation a été illustré sur la figure 8.

La bande 6 illustrée sur cette figure comporte une succession de protubérances formant plots de contact 10 alternant avec des renfoncements 11, chaque plot 10 et renfoncement 11 correspondant à une couche de la structure active 1.

Cette solution est préférée car elle assure une bonne continuité électrique et permet de transmettre la précontrainte d'une couche à l'autre par les bordures ou lames latérales 12 qui s'étendent le long des bandes 6, de part et d'autre des fentes. Ainsi, même les zones des bandes 6 qui correspondent à des renfoncements 11 et qui ne sont pas en contact avec la bague de précontrainte 8 de la couche qui leur correspond, sont maintenues par les bagues 8 des couches immédiatement voisines.

Un autre avantage de cette solution est la parfaite continuité électrique.

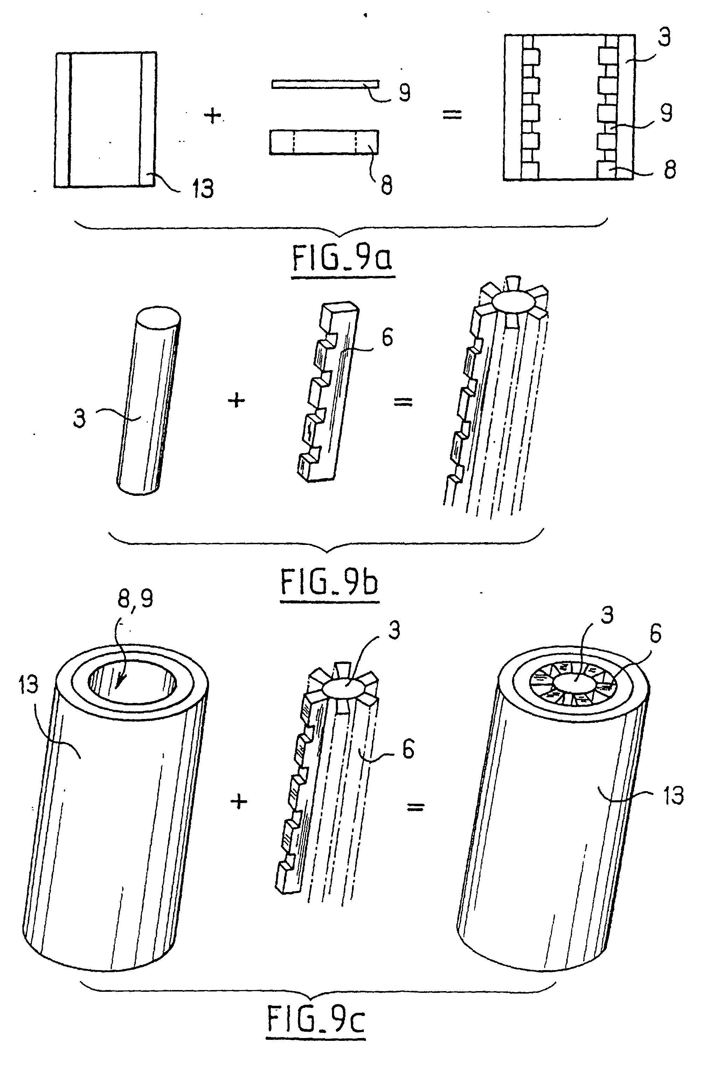

Avantageusement, la structure qui vient d'être décrite se réalise de la façon suivante (figures 9a à 9d) :

a. On prend un tube externe 13 dans lequel on empile une alternance de bagues 8 de précontrainte en phase basse température et de rondelles isolantes 9 (figure 9a),
b. Sur un noyau 3 interne cylindrique de surface isolante, on colle temporairement ou non le long des génératrices des bandes 6 métalliques fendues. Ces bandes sont décalées le long de la génératrice de l'épaisseur d'une couche (figure 9b).
c. On introduit le noyau et ses bandes dans le tube formé par les rondelles de précontrainte (figure 9c).
d. Dans les logements restant entre les bagues 8, les bandes 6 et le noyau 3, on introduit des blocs de céramique de façon que l'orientation orthoradiale de la polarisation soit la même dans chaque couche de l'empilement ainsi réalisé et soit alternée d'une couche à l'autre.
e. On chauffe l'ensemble ou l'extérieur de façon à provoquer le changement de phase des bagues de précontrainte 8. La température à laquelle lesdites bagues sont portées doit être inférieure à la température de Curie des céramiques pour ne pas provoquer la dépolarisation.
f. Selon l'utilisation ultérieure, on retire ou non le tube externe 13 et/ou le noyau intérieur 3. Si le noyau intérieur est laissé en place, il doit présenter, grâce à sa souplesse propre ou celle de son enveloppe isolante, une raideur bien plus faible que celle de la structure active. Ledit noyau 3 peut comprendre en son centre une tige permettant d'appliquer une précontrainte axiale.

D'autres variantes de réalisation sont bien entendu encore possibles.

En particulier, dans la description qui précède on a implicitement supposé que les blocs 9 étaient en des céramiques qui travaillaient en s'allongeant ou se rétractant (coefficients de déformation piezoélectrique D33 ou D31).

Toutefois, des céramiques travaillant en cisaillement (coefficient D15) peuvent également être envisagées.

Des céramiques piezoélectrique de ce type existent aujourd'hui sous forme de céramiques massives.

Et, étant donné que des tensions de plusieurs centaines de volts peuvent être utilisées sur les actionneurs de vol, l'emploi de telles céramiques est envisageable.

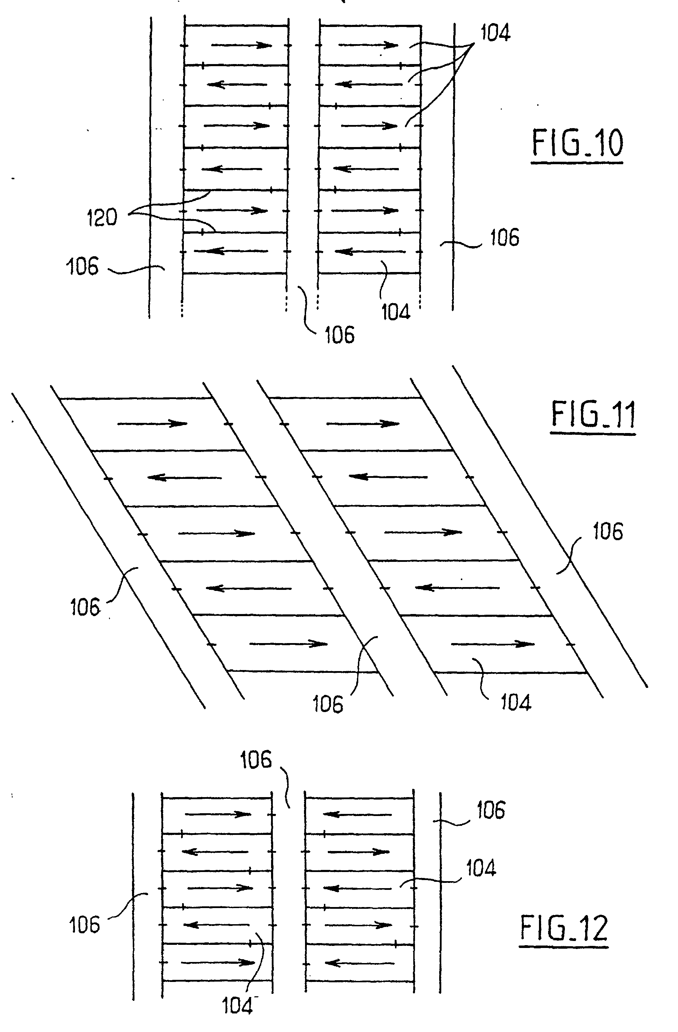

On a illustré sur les figures 10 et 11 une structuré d'actionneur conforme à l'invention dans laquelle les blocs, référencés par 104, sont en des matériaux piezoélectiques travaillant an cisaillement.

Ces blocs 104 sont empilés dans la hauteur de la structure (axe A) avec une alternance de leur polarisation.

Deux blocs successifs 104 d'un même empilement sont séparés par une métallisation formant électrode 120, lesdites métallisations 120 étant alternativement reliées dans la hauteur de la structure active aux bandes de séparation 106 conductrices, disposées d'un côté ou de l'autre dudit empilement.

Ainsi, en appliquant alternativement un potentiel +V ou -V aux éléments de séparation 106, on déforme la structure de la façon qui est illustrée sur la figure 11.

Dans l'exemple illustré sur les figures 10 et 11, les blocs 104 d'une même couche dans la hauteur de la structure présentent des polarisations dans le même sens et - en représentation développée - la répartition des lames 120 est symétrique de part et d'autre des éléments de séparation 106.

Toutefois, il n'est aucunement nécessaire que la polarisation des blocs 104 soit la même pour tous les blocs 104 d'une même couche d'empilement. La polarisation peut dans une même couche être alternée d'un bloc 104 à un autre, les métallisations 120 de deux blocs 104 successifs dans une même couche sont alors reliées à deux éléments de séparation 106 différents.

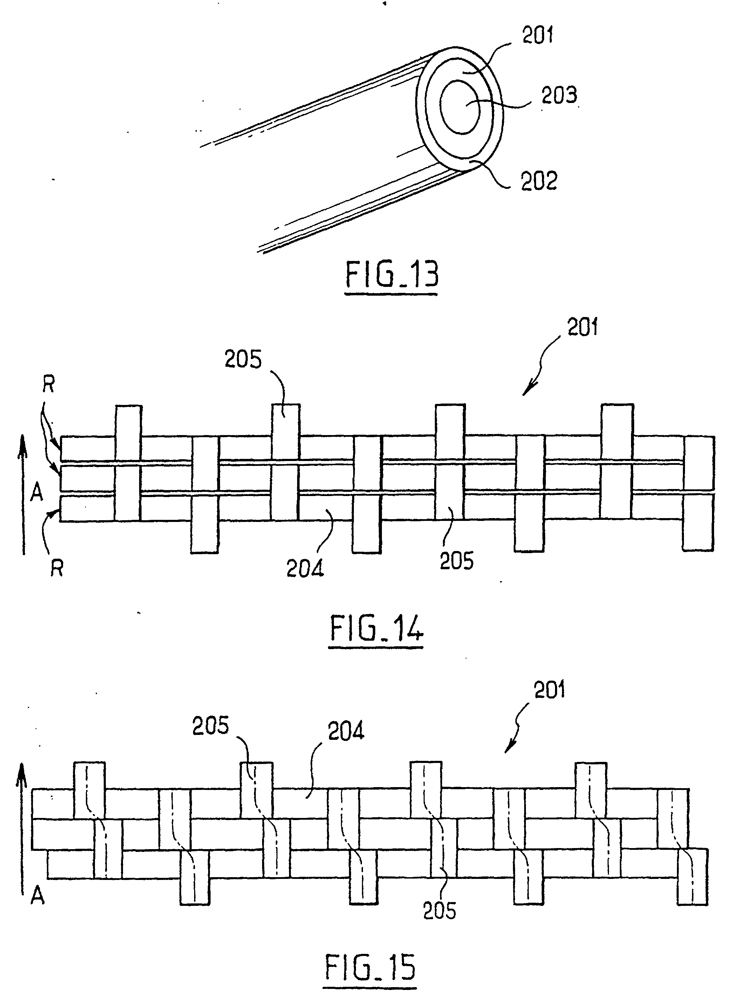

L'actionneur magnétostrictif conforme à un mode de réalisation possible qui est illustré sur la figure 13 a une forme cylindrique et comporte une structure active 201 tubulaire, ainsi qu'une enveloppe 202 dans laquelle la structure active 201 est montée et un noyau central 203.

La figure 14 représente sous forme développée une petite hauteur d'une structure active 201 conforme à un mode de réalisation possible.

L'axe A représente la direction de l'axe du cylindre.

Cette structure active comporte une pluralité de blocs ou pavés 204 en céramique magnétostrictive, qui sont empilés dans la hauteur de la structure, chaque couche d'empilement étant constituée d'une pluralité de blocs 204 qui sont juxtaposés de façon à se refermer annulairement et à constituer une rondelle R.

Sur une même couche d'empilement, les blocs 204 successifs sont séparés deux à deux par des éléments de séparation 205 inertes (pavés métalliques), qui s'étendent chacun sur deux couches d'empilement. Ces éléments de séparation sont en des matériaux de raideurs plus élevées que celles de la céramique des blocs 204 et sont par exemple en acier.

Les éléments de séparation 205 successifs d'une même couche d'empilement s'étendent alternativement à travers l'une et l'autre des deux couches d'empilement de part et d'autre de la couche d'empilement considérée et constituent des éléments de séparation pour les blocs 204 de respectivement l'une et l'autre de ces deux autres couches.

Deux éléments de séparation 205 successifs dans la hauteur de l'axe A de la structure sont en contact l'un avec l'autre, mais sont aptes à se décaler l'un par rapport à l'autre.

On applique sur les blocs 204 des champs magnétiques radiaux qui sont tels que les blocs 204 d'une même couche sont déformés de telle façon que deux blocs successifs d'une même couche ou deux blocs successifs dans la hauteur de la structure sont l'un rétréci, l'autre allongé et qu'il se produit un mouvement de décalage de chaque couche par rapport à sa voisine et que la structure active 201 se vrille.

C'est ce qu'illustre la figure 14. Les éléments de séparation 205 (métal) sont en un matériau choisi de façon à présenter une déformation qui est négligeable par rapport à celle de la céramique des blocs 204 (grande différence de module d'Young).

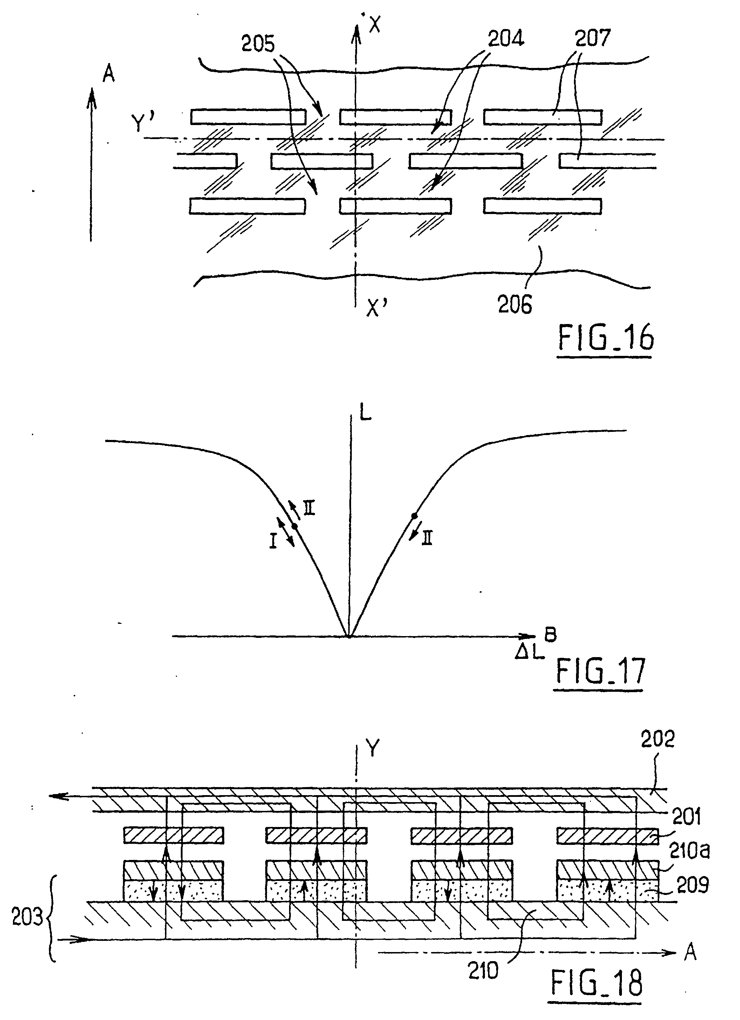

On peut également prévoir que ces bandes de séparation sont d'une pièce avec les blocs 204, auquel cas on aboutit à une structure active du type de celle illustrée sur la figure 15, constituée d'un tube 206 en un matériau magnétostrictif présentant une pluralité de fentes 207 réparties en quinconce, les zones correspondant aux pavés 205 étant définies entre les fentes 207 dont les fentes sont situées sur une même génératrice dans la hauteur de la structure, les zones où vont se produire les effets de magnétostriction lors de l'application d'un champ magnétique radial et qui correspondent aux blocs 204 (zones hachurées sur la figure 16) étant celles délimitées entre les portions qui se recouvrent des fentes 207 situées à deux hauteurs successives de la structure.

Comme la magnétostriction est un phénomène pair, c'est-à-dire ne dépendant pas du signe du champ (c.f. figure 17), il convient d'appliquer un champ magnétique de polarisation pour que chaque zone présente un effet mécanique alterné aussi bien selon l'axe du cylindre que dans une direction orthoradiale.

Deux possibilités existent :

- soit mettre un champ magnétique radial permanent uniforme sur tout le cylindre et ajouter un champ de commande radial alterné d'une zone sur l'autre (flèche double I sur la figure 17) ;
- soit mettre un champ radial permanent alterné d'une zone sur l'autre et ajouter un champ de commande radial uniforme pour la commande (flèches simples II sur la figure 17).

Une structure correspondant à cette deuxième possibilité est illustrée sur la figure 18 et décrite de façon détaillée dans la suite du présent texte.

On peut toutefois imaginer également des structures intermédiaires où le champ radial permanent au lieu d'être constant est alterné sur des zones plus grandes, l'alternance du champ de commande étant décalé lors d'un passage d'une zone à l'autre.

Une autre structure intermédiaire consisterait en une structure dans laquelle un champ de commande radial alterné sur de grandes zones, l'alternance du champ permanent étant décalée au passage d'une zone à l'autre.

La structure illustrée sur la figure 18 est une représentation en demi-coupe radiale.

L'enveloppe 202 y est en un matériau magnétique doux, par exemple en métal.

Le noyau 203 y est constitué d'une tige 210 en un matériau magnétique doux (métal) qui porte une pluralité d'aimants 209 qui sont en regard des zones 204. Ces aimants 209 présentent une polarisation qui est alternée à la fois dans la hauteur et sur le pourtour de la tige 210.

Ces aimants sont par exemple interposés entre ladite tige 210 et des éléments 210a en un matériau magnétique doux en regard de la structure active 201.

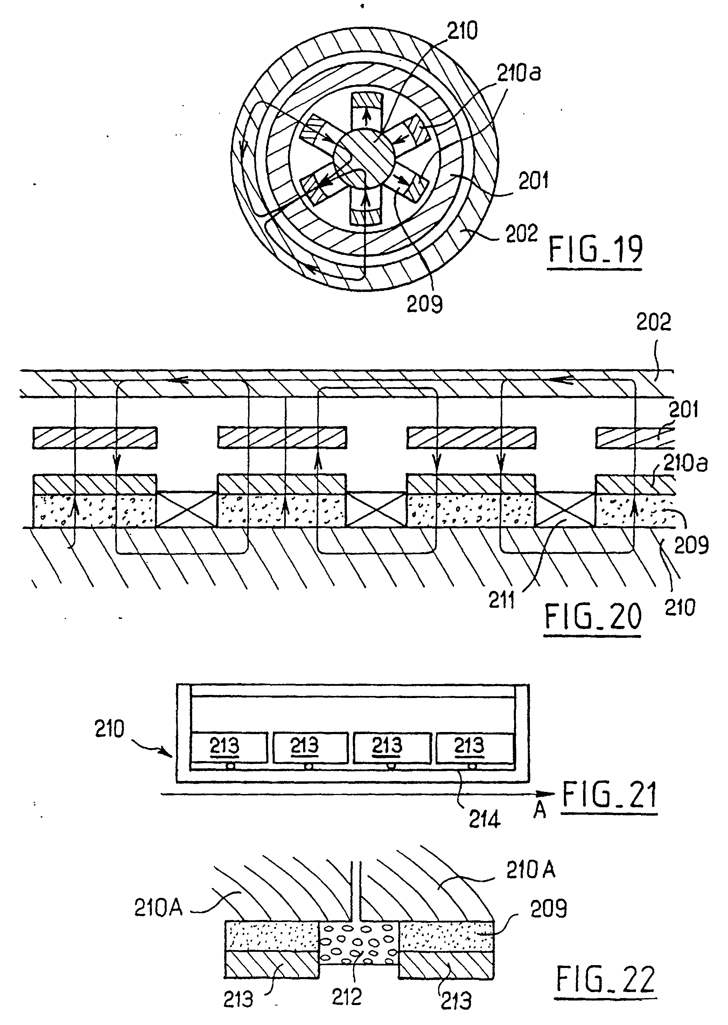

L'alternance des polarisations des aimants 209 produit l'alternance des champs permanents dans le matériau magnétostrictive. Ainsi que le montre la figure 19, cette alternance a lieu également dans la direction orthoradiale.

A l'extrémité du noyau 203 se trouve la bobine de commande qui injecte un champ axial qui se referme par l'enveloppe extérieure.

Le champ de commande se referme d'une manière uniforme à travers le matériau magnétostrictif à condition que la réluctance du noyau 203 et de la fermeture soit faible devant celles des entrefers. Ceci n'est pas forcément vérifié lorsque le cylindre est très long. Pour cela on peut être amené, ainsi qu'illustré sur la figure 20 , à alterner les sens des champs de commande en plaçant régulièrement des bobines de commande 211 le long de la tige 210. Ceci réduit la réluctance vue par chaque bobine.

On notera que le structure qui vient d'être décrite est particulièrement avantageuse étant donné que la fermeture du champ constant se fait orthoradialement dans la fermeture à cause de l'alternance orthoradiale des polarisations des aimants. Le dispositif n'est pas sensible à longueur.

Toutefois, lorsque la structure active se tord selon l'axe du cylindre les pôles du noyau ne se trouvent plus en face des zones 204 qu'il convient d'exciter. Il convient donc que le noyau 203 puisse se tordre également comme la structure active 201 tout en ayant une raideur beaucoup plus faible. Pour cela le noyau 203 doit être solidaire de la structure active 201 à ses extrémités.

La tige 210 est à cet effet avantageusement composée de plusieurs tronçons 213 liés entre eux par une barre de torsion axiale 214 de faible diamètre si elle est métallique ou de plus fort diamètre s'il s'agit d'un élastomère. C'est ce qu'on a illustré sur la figure 21 (demi-coupe axiale) sur laquelle les points représentent les points de liaison des éléments du noyau avec la barre de torsion.

On peut également faire une liaison entre deux éléments 210a du noyau par des rondelles 212 en élastomère placée entre les différentes couches de pole.

C'est ce qu'illustre la figure 22.

Ces rondelles 212 en élastomère peuvent également revêtir la bobine de commande.

## Revendications

**1.** Actionneur, **caractérisé en ce qu'**il comporte une pluralité d'empilements de blocs élémentaires (4, 204) en un matériau actif de type piezoélectrique, électrostrictif ou magnétostrictif, qui sont répartis en plusieurs couches empilées dans lesquelles ils sont juxtaposés en étant refermés de façon à former une structure tubulaire (1, 201) ainsi que des moyens permettant d'appliquer sur lesdits blocs élémentaires (4, 204) un champ électrique ou magnétique déformant lesdits blocs élémentaires de telle sorte que la structure tubulaire se vrille.

**2.** Actionneur selon la revendication 1, **caractérisé en ce que** les blocs élémentaires (4) sont piézoélectriques ou électrostrictifs et **en ce que** les moyens pour déformer lesdits blocs comportent des moyens formant électrodes permettant d'appliquer des champs électriques sur lesdits blocs.

**3.** Actionneur selon la revendication 2, **caractérisé en ce que** les blocs élémentaires travaillent en allongement/rétractation et **en ce qu'**ils sont empilés avec une polarisation alternée dans la hauteur de la structure tubulaire.

**4.** Actionneur selon la revendication 3, **caractérisé en ce que** les empilements sont séparés deux à deux par des moyens de séparation (5) qui s'étendent selon la hauteur de la structure et **en ce que** les éléments de séparation (5) sont constitués d'une succession de pavés qui présentent chacun une hauteur correspondant au moins à la hauteur de deux blocs élémentaires (4), ces pavés étant aptes à glisser les uns sur les autres et étant d'un raideur supérieure à celle des blocs élémentaires, les zones de séparation entre les pavés superposés selon une même hauteur étant, d'un moyen de séparation à un autre, décalés dans la hauteur de la structure.

**5.** Actionneur selon la revendication 4, **caractérisé en ce que** les moyens de séparation (5) sont constitués par des bandes (6) qui présentent une pluralité de fentes (7) qui délimitent deux à deux les pavés.

**6.** Actionneur selon la revendication 4, **caractérisé en ce que** les moyens de séparation (5) sont constitués par une pluralité d'éléments de séparation qui sont superposés et qui constituent chacun un pavé élémentaire.

**7.** Actionneur selon la revendication 4, **caractérisé en ce que** les moyens formant électrodes sont constitués par les moyens de séparation (5).

**8.** Actionneur selon la revendication 2, **caractérisé en ce que** les blocs élémentaires (4) travaillent en cisaillement.

**9.** Actionneur selon la revendication 8, **caractérisé en ce que** deux blocs élémentaires (4) successifs dans la hauteur d'un même empilement présentent des métallisations formant électrode sur leurs faces en regard.

**10.** Actionneur selon la revendication 9, **caractérisé en ce que** les empilements de blocs élémentaires (4) sont séparés par des moyens de séparation électriquement conducteurs auxquels les métallisations formant électrode sont reliées.

**11.** Actionneur selon l'une des revendications précédentes, **caractérisé en ce que** les blocs élémentaires sont répartis en rondelle (R) dans la hauteur de la structure tubulaire.

**12.** Actionneur selon l'une des revendications précédentes, **caractérisé en ce qu'**il comporte une enveloppe de précontrainte (2, 202) dans laquelle la structure tubulaire à blocs élémentaires (4, 204) est disposée.

**13.** Actionneur selon les revendications 11 et 12, **caractérisé en ce que** l'enveloppe de précontrainte (2) comprend une pluralité de bagues 8 de précontrainte assurant chacune la précontrainte d'une rondelle de blocs élémentaires de la structure tubulaire.

**14.** Actionneur selon la revendication 13 prise en combinaison avec l'une des revendications 7 ou 10, **caractérisé en ce que** les bagues (8) sont électriquement conductrices et **en ce qu'**il comporte une pluralité de plots de contacts (10) répartis dans la hauteur de la structure entre les moyens de séparation (5) et les bagues (8) de précontraintes.

**15.** Actionneur selon la revendication 14 prise en combinaison avec la revendication 5, **caractérisé en ce que** les plots de contact (10) sont répartis de façon a être en contact avec un pavé (5, 6) sur deux.

**16.** Actionneur selon l'une des revendications 14 et 15, **caractérisé en ce que** les bagues (8) Sont séparées par des rondelles électriquement isolantes (9).

**17.** Actionneur selon l'une des revendications 13 à 16, **caractérisé en ce que** l'enveloppe (2) ou les bagues (8) de précontrainte est ou sont en un alliage à mémoire de forme.

**18.** Procédé pour la réalisation d'un actionneur selon les revendications 16 et 17 prises en combinaison, **caractérisé en ce que**

a. On empile dans un tube (13) externe une alternance de bagues (8) de précontrainte en phase basse température et de rondelles isolantes (9),
b. On colle le long des génératrices d'un noyau interne cylindrique de surface isolante, des bandes (6) métalliques fendues, en les décalant deux à deux, le long dudit noyau, d'une demi épaisseur de noyau.
c. On introduit le noyau (3) et ses bandes (6) dans la structure tubulaire que constituent les bagues (8) de précontrainte et les rondelles (9).
d. On introduit les blocs élémentaires (4) dans les logements entre les bagues (8), les bandes (6) et le noyau (3).
e. On chauffe l'ensemble de façon à provoquer le changement de phase des bagues (8) de précontrainte.

**19.** Actionneur selon la revendication 1, **caractérisé en ce que** les blocs élémentaires de la structure active tubulaire (201) comprennent une pluralité d'empilements de pavés (204) destinés à être déformés par effet magnétostrictif entre lesquels sont interposés des moyens de séparation (205) constitués d'empilements de pavés de séparation présentant chacun une hauteur correspondant au moins à la hauteur de deux pavés destinés à être déformés par effet magnétostrictif, les différents pavés superposés dans une hauteur de la structure active étant aptes à glisser les uns sur les autres, les zones de séparation entre les pavés de séparation superposés selon une même hauteur étant, d'un moyen de séparation à un autre, décalés dans la hauteur de la structure, l'actionneur comportant en outre des moyens pour appliquer sur les pavés destinés à être déformés par effet magnétostrictif un champ magnétique qui produit, de façon alternée dans la hauteur de la structure et sur le tour de celle-ci, la rétractation et l'allongement desdits pavés.

**20.** Actionneur selon la revendication 19, **caractérisé en ce que** la structure active (201) est un tube (206) en un matériau magnétostrictif, qui présente une pluralité de fentes (207) disposées en quinconce qui définissent entre elles des zones correspondant aux pavés destinés à être déformés par effet magnétostrictif et des zones correspondant aux pavés de séparation.

**21.** Actionneur selon l'une des revendications 19 et 20, **caractérisé en ce qu'**il comporte des moyens pour appliquer un champ magnétique radial permanent uniforme sur la structure active et pour ajouter à ce champ permanent un champ de commande radial qui est alterné d'un pavé qui est destiné à être déformé par effet magnétostrictif à un autre.

**22.** Actionneur selon l'une des revendications 19 et 20, **caractérisé en ce qu'**il comporte des moyens pour appliquer sur la structure active un champ radial permanent alterné d'un pavé qui est destiné à être déformé par effet magnétostrictif à un autre et pour ajouter à ce champ permanent un champ de commande radial uniforme.

**23.** Actionneur selon l'une des revendications 19 à 22, **caractérisé en ce qu'**il comporte des aimants permanents en regard des différents pavés destinés à être déformés par effet magnétostrictif.

24. Actionneur selon les revendications 22 et 23 prises en combinaison, **caractérisé en ce que** les aimants permanents présentent une polarisation qui est alternée d'un aimant à un autre.

25. Actionneur selon la revendication 23, **caractérisé en ce que** les aimants permanents sont portés par un noyau (203) qui comprend une pluralité de tronçons (213) aptes à tourner les uns par rapport aux autres et **en ce qu'**il comporte en outre des moyens pour communiquer à ces tronçons le mouvement de vrille de la structure active.

26. Actionneur selon la revendication 25, **caractérisé en ce que** lesdits moyens comportent une barre de torsion axiale (214)

27. Actionneur selon la revendication 25, **caractérisé en ce que** lesdits moyens comportent des liaisons (212) en élastomère entre des aimants permanents successifs dans la hauteur de la structure active.

**Patentansprüche**

1. Antrieb, **dadurch gekennzeichnet, dass** er mehrere Stapel von Elementarblöcken (4, 204) aus einem aktiven piezoelektrischen, elektrostriktiven oder magnetostriktiven Material, die derart in mehreren gestapelten Schichten angeordnet sind, in denen sie dicht benachbart sind, dass sie eine röhrenförmige Struktur (1, 201) bilden, sowie Einrichtungen umfasst, mit denen an die Elementarblöcke (4, 204) ein elektrisches oder magnetisches Feld angelegt werden kann, wodurch die Elementarblökke derart Verformt werden, dass sich die röhrenförmige Struktur verdrillt.

2. Antrieb nach Anspruch 1, **dadurch gekennzeichnet, dass** die Elementarblöcke (4) piezoelektrisch oder elektrostriktiv sind und die Einrichtung zum Verformen der Blöcke Einrichtung umfassen, die Elektroden bilden, welche das Anlegen von elektrischen Feldern an die Blöcke ermöglicht.

3. Antrieb nach Anspruch 2, **dadurch gekennzeichnet, dass** die Elementarblöcke verlängernd/verkürzend arbeiten und dass sie über die Höhe der röhrenförmigen Struktur mit alternierender Polarisation gestapelt sind.

4. Antrieb nach Anspruch 3, **dadurch gekennzeichnet, dass** die Stapel durch Trenneinrichtungen (5) in Paare unterteilt werden, die sich über die Höhe der Struktur erstrecken, und dass die Trennelemente (5) aus einer Abfolge von Platten bestehen, die jeweils eine Höhe aufweisen, die wenigstens der Höhe von zwei Elementarblöcken (4) entspricht, wobei die Platten aufeinander gleiten können und eine Steifigkeit haben, die größer als die von den Elementarblöcken ist, wobei die Trennzonen zwischen den auf einer gleichen Höhe übereinander angeordneten Platten von einer Trenneinrichtung zu einer anderen über die Höhe der Struktur versetzt sind.

5. Antrieb nach Anspruch 4, **dadurch gekennzeichnet, dass** die Trenneinrichtungen (5) aus Streifen (6) bestehen, die mehrere Spalte (7) aufweisen, durch welche paarweise die Platten begrenzt werden.

6. Antrieb nach Anspruch 4, **dadurch gekennzeichnet, dass** die Trenneinrichtungen (5) aus mehreren Trennelementen bestehen, die übereinander angeordnet sind und jeweils ein Plattenelement bilden.

7. Antrieb nach Anspruch 4, **dadurch gekennzeichnet, dass** die Einrichtungen, die die Elektroden bilden, aus Trenneinrichtungen (5) gebildet werden.

8. Antrieb nach Anspruch 2, **dadurch gekennzeichnet, dass** die Elementarblöcke (4) in Scherung arbeiten.

9. Antrieb nach Anspruch 8, **dadurch gekennzeichnet, dass** zwei Elementarblöcke (4), die in der Höhe einer gleichen Stapelung aufeinander folgen, Metallisierungen aufweisen, die eine Elektrode auf ihren gegenüberliegenden Flächen bildet.

10. Antrieb nach Anspruch 9, **dadurch gekennzeichnet, dass** Stapel der Elementarblöcke (4) durch elektrisch leitfähige Trenneinrichtungen getrennt werden, mit denen die Metallisierungen verbunden sind, die die Elektrode bilden.

11. Antrieb nach einem der vorangehenden Ansprüche, **dadurch gekennzeichnet, dass** die Elementarblöcke als Scheibe (R) über die Höhe der Röhrenstruktur angeordnet sind.

12. Antrieb nach einem der vorangehenden Ansprüche, **dadurch gekennzeichnet, dass** er eine Vorspannungsummantelung (2, 202) umfasst, in welcher sich die Röhrenstruktur aus den Elementarblöcken (4, 204) befindet.

13. Antrieb nach Anspruch 11 oder 12, **dadurch gekennzeichnet, dass** die Vorspannungsummantelung (2) mehrere Vorspannungsringe (8) umfasst, die jeweils die Vorspannung einer Scheibe aus den Elementarblöcken der Röhrenstruktur sicherstellen.

**14.** Antrieb nach Anspruch 13 in Verbindung mit einem der Ansprüche 7 oder 10, **dadurch gekennzeichnet, dass** die Ringe (8) elektrisch leitfähig sind und dass er mehrere Kontaktbereiche (10) aufweist, die über die Höhe der Struktur zwischen den Trenneinrichtungen (5) und den Vorspannungsringen (8) angeordnet sind.

**15.** Antrieb nach Anspruch 14, **dadurch gekennzeichnet, dass** die Kontaktbereiche (10) derart angeordnet sind, dass sie mit einer von zwei Platten (5, 6) in Kontakt stehen.

**16.** Antrieb nach Anspruch 14 oder 15, **dadurch gekennzeichnet, dass** die Ringe (8) durch elektrisch isolierende Scheiben (9) getrennt sind.

**17.** Antrieb nach einem der Ansprüche 13 bis 16, **dadurch gekennzeichnet, dass** die Vorspannungsummantelung (2) oder die Vorspannungsringe (8) aus einer Legierung mit Formgedächtnis besteht oder bestehen.

**18.** Verfahren zum Herstellen eines Antriebs nach Anspruch 16 oder 17, **dadurch gekennzeichnet, dass**

a) in einer Außenröhre (13) abwechselnd Vorspannungsringe (8) in einer Niedertemperaturphase und Isolatorscheiben (9) aufeinander gestapelt werden,
b) entlang der Erzeugenden eines zylindrischen Innenkerns mit isolierender Oberfläche metallische, geschlitzte Streifen (6) mit der halben Dicke des Kerns geklebt werden, wobei sie paarweise entlang des Kerns versetzt werden,
c) der Kern (3) und seine Streifen (6) in die Röhrenstruktur eingeführt werden, gebildet durch die Vorspannungsringe (8) und die Scheiben (9),
d) die Elementarblöcke (4) in die Aufnahmen zwischen die Ringe (8), die Streifen (6) und den Kern(3) eingeführt werden,
e) der Aufbau aufgeheizt wird, so dass eine Phasenänderung der Vorspannungsringe (8) hervorgerufen wird.

**19.** Antrieb nach Anspruch 1, **dadurch gekennzeichnet, dass** die Elementarblöcke der aktiven, röhrenförmigen Struktur (201) mehrere Stapel aus Platten (204) umfassen, die durch Magnetostriktion deformiert werden können und zwischen denen Trenneinrichtungen (205) angeordnet sind, die aus Stapeln von Trennplatten bestehen, die jeweils eine Höhe aufweisen, die wenigstens der Höhe von zwei Platten entspricht, die durch Magnetostriktion deformiert werden können, wobei die verschiedenen, in einer Höhe der aktiven Struktur übereinander angeordneten Platten aufeinander gleiten können, wobei die Trennzonen zwischen den in einer gleichen Höhe übereinander angeordneten Trennplatten von einer Trenneinrichtung zu einer anderen in der Höhe er Struktur versetzt sind, wobei der Antrieb außerdem Einrichtungen umfasst zum Anlegen eines Magnetfeldes an die Platten, die durch Magnetostriktion deformiert werden sollen, das in der Höhe der Struktur und um sie herum alternierend das Zusammenziehen und Verlängern der Platten bewirkt.

**20.** Antrieb nach Anspruch 19, **dadurch gekennzeichnet, dass** die aktive Struktur (201) eine Röhre (206) aus einem magnetostriktiven Material ist, das mehrere wechselständige Spalten (207) aufweist, zwischen denen Zonen, die den Platten entsprechen, die durch Magnetostriktion verformt werden, und Zonen, die den Trennplatten entsprechen, definiert sind.

**21.** Antrieb nach Anspruch 19 oder 20, **dadurch gekennzeichnet, dass** er Einrichtungen umfasst zum Anlegen eines radialen, permanenten, gleichförmigen Magnetfeldes an die aktive Struktur und zum Überlagern des permanenten Feldes mit einem radialen Steuerfeld, das von einer Platte, die durch Magnetostriktion deformiert werden soll, zu einer anderen wechselt.

**22.** Antrieb nach Anspruch 19 oder 20, **dadurch gekennzeichnet, dass** er Einrichtungen umfasst zum Anlegen eines radialen, permanenten, Feldes an die aktive Struktur, das von einer Platte, die durch Magnetostriktion deformiert werden soll, zu einer anderen wechselt, und zum Überlagern dieses Feldes mit einem radialen, gleichförmigen Steuerfeld.

**23.** Antrieb nach einem der Ansprüche 19 bis 22, **dadurch gekennzeichnet, dass** er Dauermagneten gegenüber den verschiedenen Platten umfasst, die durch Magentostriktion verformt werden sollen.

**24.** Antrieb nach Anspruch 22 in Verbindung mit 23, **dadurch gekennzeichnet, dass** die Dauermagnete eine Polarisation aufweisen, die von einem Magneten zum anderen wechselt.

**25.** Antrieb nach Anspruch 23, **dadurch gekennzeichnet, dass** die Dauermagnete von einem Kern (203) getragen werden, der mehrere Abschnitte (213) aufweist, mit denen die einen in Bezug auf die anderen gedreht werden können, und dass er außerdem Einrichtung zum Übertragen der Verdrillungsbewegung der aktiven Struktur auf diese Abschnitte aufweist.

**26.** Antrieb nach Anspruch 25, **dadurch gekennzeich-**

**net, dass** die Einrichtungen eine Axialtorsionsstange (214) aufweisen.

27. Antrieb nach Anspruch 25, **dadurch gekennzeichnet, dass** die Einrichtungen Elastomer-Verbindungen (212) zwischen den Dauermagneten aufweisen, die in der Höhe der aktiven Struktur aufeinanderfolgen.

**Claims**

1. An actuator, **characterized in that** it comprises a plurality of stacks of unit blocks (4, 204) of an active material of the piezoelectric, electrostrictive, or magnetostrictive type, which blocks are distributed in a plurality of stacked layers in which they are juxtaposed by being closed so as to form a tubular structure (1, 201), together with means enabling an electric or magnetic field to be applied to said unit blocks (4, 204) to cause said unit blocks to deform in such a manner that the tubular structure twists.

2. An actuator according to claim 1, **characterized in that** the unit blocks (4) are piezoelectric or electrostrictive, and **in that** the means for deforming said blocks comprise means forming electrodes enabling electric fields to be applied to said blocks.

3. An actuator according to claim 2, **characterized in that** the unit blocks work in elongation/retraction and **in that** they are stacked with polarization that alternates in the height direction of the tubular structure.

4. An actuator according to claim 3, **characterized in that** the stacks are separated in pairs by separator means (15) extending along the height direction of the structure, and **in that** the separator elements (5) are constituted by a succession of slabs each being of a height that corresponds at least to the height of two unit blocks (4), the slabs being suitable for sliding relative to one another and being of stiffness that is greater than that of the unit blocks, the separator zones between superposed slabs at the same height being offset in the height direction of the structure from one separator means to the next in the circumferential direction.

5. An actuator according to claim 4, **characterized in that** the separator means (5) are constituted by strips (6) presenting a plurality of slots (7) that, in pairs, define the slabs.

6. An actuator according to claim 4, **characterized in that** the separator means (5) are constituted by a plurality of separator elements which are superposed, each of which constitutes a unit slab.

7. An actuator according to claim 4, **characterized in that** the electrode-forming means are constituted by the separator means (5).

8. An actuator according to claim 2, **characterized in that** the unit blocks (4) operate in shear.

9. An actuator according to claim 8, **characterized in that** two successive unit blocks (4) in the height direction of a given stack present electrode-forming metallizations on their facing faces.

10. An actuator according to claim 9, **characterized in that** the stacks of unit blocks (4) are separated by electrically conductive separator means to which the electrode-forming metallizations are connected.

11. An actuator according to any preceding claim, **characterized in that** the unit blocks are distributed as washers (R) in the height direction of the tubular structure.

12. An actuator according to any preceding claim, **characterized in that** it includes a prestress envelope (2, 202) in which the tubular structure of unit blocks (4, 204) is placed.

13. An actuator according to claims 11 and 12, **characterized in that** the prestress envelope (2) comprises a plurality of prestress rings (8) each providing prestress to a washer of unit blocks of the tubular structure.

14. An actuator according to claim 13, taken in combination with claim 7 or 10, **characterized in that** the rings (8) are electrically conductive and **in that** the actuator comprises a plurality of contact areas (10) distributed in the height direction of the structure between the separator means (5) and the prestress rings (8).

15. An actuator according to claim 14, taken in combination with claim 5, **characterized in that** the contact areas (10) are distributed so as to make contact with every other slab (5, 6).

16. An actuator according to claim 14 or 15, **characterized in that** the rings (8) are separated by electrically insulating washers (9).

17. An actuator according to any one of claims 13 to 16, **characterized in that** the envelope (2) or the prestress rings (8) is/are made of an alloy having shape memory.

18. A method of making an actuator according to claims 16 and 17 taken in combination, the method being **characterized in that**:

a) insulating washers (9) and prestress rings (8) in the low temperature phase are stacked in alternation inside an outer tube (13);

b) split metal strips (6) are stuck along generator lines of a cylindrical inner core having an insulating surface, adjacent pairs of strips being offset relative to one another in the length direction of said core by half the thickness of the core;

c) the core (3) is inserted together with its strips (6) into the tubular structure constituted by the prestress rings (8) and the washers (9);

d) the unit blocks (4) are inserted into the housings between the rings (8), the strips (6), and the core (3); and

e) the assembly is heated to change the phase of the prestress rings (8).

19. An actuator according to claim 1, **characterized in that** the unit blocks of the tubular active structure (201) comprise a plurality of stacks of blocks (204) designed to be deformed by the magnetostrictive effect, with separator means (205) being interposed between the blocks, the separator means being constituted by stacks of separator slabs each being of a height that corresponds at least to the height of two blocks that are to be deformed by the magnetostrictive effect, the various superposed slabs in the height direction of the active structure being suitable for sliding relative to one another, the separation zones between superposed separator slabs at the same height being, from one separation means to another, offset in the height direction of the structure, the actuator further including means for applying a magnetic field to the blocks that are to be deformed by the magnetostrictive effect, thereby causing said blocks to shrink and to lengthen in alternating manner in the height direction of the structure and around it.

20. An actuator according to claim 19, **characterized in that** the active structure (201) is a tube (206) of magnetostrictive material having a plurality of slots (207) disposed in a staggered configuration and defining between them both zones corresponding to the blocks that are designed to be deformed by the magnetostrictive effect, and zones corresponding to the separator slabs.

21. An actuator according to claim 19 or 20, **characterized in that** it includes means for applying a uniform permanent radial magnetic field to the active structure and for adding to said permanent field a radial control field which alternates from one block that is to be deformed by the magnetostrictive effect to another.

22. An actuator according to claim 19 or 20, **characterized in that** it comprises means for applying a permanent radial field to the active structure that alternates from one block which is designed to be deformed by the magnetostrictive effect to the next, and in adding to said permanent field a radial control field that is uniform.

23. An actuator according to any one of claims 19 to 22, **characterized in that** it has permanent magnets in register with different blocks designed to be deformed by the magnetostrictive effect.

24. An actuator according to claims 22 and 23 in combination, **characterized in that** the permanent magnets are of polarization that alternates from open magnet to the next.

25. An actuator according to claim 23, **characterized in that** the permanent magnets are carried by a core (203) which comprises a plurality of segments (213) suitable for turning relative to one another, and **in that** it further includes means for communicating the twisting movement of the active structure to said segments.

26. An actuator according to claim 25, **characterized in that** said means comprise an axial torsion bar (214).

27. An actuator according to claim 25, **characterized in that** said means comprise elastomer links (212) between successive permanent magnets in the height direction of the active structure.

FIG.1

FIG.2

FIG.3

FIG_4

FIG.5

FIG.6

FIG.7

FIG.8

FIG.9a

FIG.9b

FIG.9c

FIG.10

FIG.11

FIG.12

201
203
202

FIG. 13

R
205
201
A
204
205
R

FIG. 14

205
204
201
A
205

FIG. 15

FIG.16

FIG.17

FIG.18

FIG_19

FIG_20

FIG_21

FIG_22